**Europäisches Patentamt**

**European Patent Office**

**Office européen des brevets**

(19)

(11) Veröffentlichungsnummer: **0 006 975**
**B1**

# EUROPÄISCHE PATENTSCHRIFT

(12)

(45) Veröffentlichungstag der Patentschrift: **03.02.82**

(21) Anmeldenummer: **79101208.1**

(22) Anmeldetag: **20.04.79**

(51) Int. Cl.³: **G 11 C 19/28,**
**G 11 C 19/18, H 01 L 27/02**

(54) **Verfahren zum zerstörungsfreien Auslesen eines Signals aus einem CCD-Schieberegister und Vorrichtung zur Durchführung des Verfahrens.**

(30) Priorität: **12.05.78 DE 2820973**

(43) Veröffentlichungstag der Anmeldung:
**23.01.80 Patentblatt 80/2**

(45) Bekanntmachung des Hinweises auf die Patenterteilung.
**03.02.82 Patentblatt 82/5**

(84) Benannte Vertragsstaaten:
**BE FR GB IT NL**

(56) Entgegenhaltungen:
**DE - A - 2 631 495 (NORTHERN TELECOM)**
***ganzes Dokument***
**US - A - 4 047 051 (HELLER)**
***Seite 1***
**US - A - 4 071 775 (HEWES)**
***ganzes Dokument***

**CARLO H. SEQUIN et al, "Charge transfer devices", 1975, Academic Press, Inc. New York, San Francisco, London**

(73) Patentinhaber: **SIEMENS AKTIENGESELLSCHAFT**
**Berlin und München**
**Postfach 22 02 61**
**D-8000 München 22 (DE)**

(72) Erfinder: **Mauthe, Manfred, Dipl.-Ing.**
**Mauthäuslstrasse 39**
**D-8000 München 70 (DE)**
Erfinder: **Pfleiderer, Hans-Jörg, Dr.**
**Franz-Krinninger-Weg 23**
**D-8011 Zorneding (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

# 0 006 975

### Verfahren zum zerstörungsfreien Auslesen eines Signals aus einem CCD-Schieberegister und Vorrichtung zur Durchführung des Verfahrens

Die Erfindung betrifft ein Verfahren zum zerstörungsfreien Auslesen eines Signals aus einem Schieberegister entsprechend dem Oberbegriff des Anspruchs 1, sowie eine Vorrichtung zur Durchführung des Verfahrens. Das Schieberegister besteht dabei aus auf einem dotierten Halbleiterkörper integrierten ladungsgekoppelten Metallelektrode-Isolator-Halbleiter-Kondensatoren. Das Potential an der Halbleiteroberfläche unter einer Kondensatorelektrode wird abgetastet und als Steuer befehl auf eine spannungsgesteuerte Steuereinrichtung gegeben.

In der Elektronik werden zum Speichern und Verarbeiten von Signalfolgen häufig sog. CCD-(Charge-Coupled-Devices)-Schieberegister verwendet. Dabei handelt es sich um einen dotierten Halbleiterkörper, dessen Oberfläche von einer dünnen Isolatorschicht bedeckt ist, über der eng nebeneinanderliegende Elektroden aus Metall oder einem gut leitendem Material (z.B. hochdotiertem Polysilizium) angeordnet sind. Es entsteht dadurch eine Reihe kapazitiv gekoppelter Metallelektrode-Isolator-Halbleiter-(MIS)-Kondensatoren. Werden die Elektroden derart gegenüber dem Halbeleiterkörper vorgespannt, daß die Majoritätsträger vom Substantanschluß abgezogen werden, so entsteht unter den Elektroden eine Verarmungsschicht, die keine Ladungsträger enthält oder, falls Minoritätsträger von außen eingebracht sind, diese Minoritätsträger speichert, sofern diese Elektrode stärker gegenüber dem Substrat vorgespannt ist als die Nachbarelektroden. Wird nun eine Nachbarelektrode mit einer erhöhten Spannung angesteuert, so entsteht beim Rücksetzen der ersten Elektrode auf das Ruhe-potential ein Potential-gefälle zur zweiten Elektrode hin und die Minoritätsträger fließen in diesen Kondensator ab. Die Ladung ist also von der ersten Elektrode in die zweite Elektrode verschoben und kann von dort weiter vorschoben werden.

Um nun das von einem derartigen Minoritätsträger-Paket dargestellte Signal aus dem Schieberegister auslesen zu können, sind verschiedene Verfahren und Vorrichtungen entwickelt worden, wie sie z.B. von Carlo H. Séquin und Michael F.Tompsett in "Charge Transfer Devices", New York 1975, Seiten 52 bis 59 beschrieben sind. So kann z.B. am Ende des Schieberegisters eine Ausgangs-Elektrode (Ausgangsgate) und eine entgegengesetzt zum Halbleiter dotiertes Diffusionsgebiet an der Halbleiteroberfläche vorgesehen sein, wobei das Diffusionsgebiet mit dem Eingang eines Stromverstärkers kontaktiert ist. Durch ensprechende Ansteuerung des Ausgangsgate kann das in dem letzten Kondensator des Schieberegisters anstehende Ladungspaket in das Diffusionsgebiet verschoben werden und fließt in den Stromverstärker ab. Durch eine Rückkopplung am Stromverstärker wird das Ausgangsgebiet auf einer festen Spannung gehalten.

Man kann auch neben dem Ausgangs-Diffusionsgebiet ein über Rücksetz-Elektrode mit diesem Diffusionsgebiet koppelbares zweites Diffusionsgebiet vorsehen. Das zweite Diffusionsgebiet wird dabei auf einem festen Betriebspotential gehalten, während das Ausgangsdiffusionsgebiet nur mit dem Steuergate eines MOS-Transistors verbunden ist. Bei entsprechender Ansteuerung der Rücksetzelektrode sind die beiden Diffusionsgebiete miteinander elektrisch verbunden und das Ausgangsdiffusionsgebiet liegt auf dem Betriebspotential des zweiten Diffusionsgebietes (Ruhepotential). Der Transistor, zwischen desen Drain und Source z.B. ebenfalls das Betriebspotential des zweiten Diffusionsgebietes liegen kann, befindet sich dann in einem Schaltzustand, der der Ruhestellung entspricht. Wird nun durch entsprechende Ansteuerung des Rücksetzgates die Verbindung zwischen den beiden Diffusionsgebieten getrennt, so ist das erste Diffusionsgebiet frei schwebend (Floating Diffusion). Wird dann durch Ansteuern des Ausgangsgates eine im letzten Kondensator anstehende Ladung in das Ausgangs-Diffusions-Gebiet verschoben, so liegt am Steuergate des Transistors das von der Ladung hervorgerufene Potential des Diffusionsgebietes an und verändert den Schaltzustand des Transistors entsprechend. Anschließend wird das Ausgangsdiffusionsgebiet wieder auf Ruhepotential gelegt, wobei die Ladung in das zweite Diffusionsgebiet zum zweiten Diffusionsgebiet abfließt. In beiden Fällen findet also eine Zerstörung des Signals im Schieberegister statt.

Eine Möglichkeit zum zerstörungsfreien Auslesen besteht darin, daß neben einer Kondensatorelektrode eine nur mit dem Steuergate des Transistors verbundene, elektrisch frei schwebende Elektrode (Floating Gate) angeordnet ist, die das Potential, das an der Halbleiteroberfläche in Nähe des Kondensators verliegt, abtastet. Um nach dem Auslesevorgang, d.h. wenn die Ladung aus dem Kondensator z.B. in andere Kondensatoren des Schieberegisters transportiert ist, das Potential des Floating Gates zu kontrollieren, ist eine eigene Rücksetzschaltung oder eine kapazitive Kopplung mit einer weiteren Elektrode nötig, die unmittelbar über dem Floating Gate angeordnet ist.

DE—A—2 631 495 ist ein Verfahren zum zerstörungsfreien Auslesen eines Signals aus einem CCD—Schieberegister und eine Vorrichtung zur Durchführung des Verfahrens bekannt, bei dem eine elektrisch frei schwebend gehaltene, zwischen Übertragungs-Gates angeordnete Speicherelektrode mit der Steuerelektrode eines Feldeffekttransistors verbunden ist. Die das Schieberegister durchsetzenden Ladungspakete setzen im Vorbeifließen die elektrostatische Aufladung der schwebend gehaltenen Speicherelektrode herab und verändern so das am Steuerglied des Feldeffekttransistors anliegende Potential. Durch die damit verbundene Änderung der Leitfähigkeit des Feldeffekttransistors werden die Ladungspakete abgetastet.

Der Erfindung liegt die Aufgabe zugrunde, ein zerstörungsfreies Auslesen aus einem CCD-Register

0 006 975

ohne größeren Aufwand zu ermöglichen, wobei insbesondere auf eine Rücksetzschaltung oder eine Anordnung mit übereinander angeordneten Elektroden verzichtet werden soll.

Diese Aufgabe wird gemäß der Erfindung gelöst durch ein Verfahren der eingangs angegebenen Art und die im kennzeichnenden Teil des Anspruches 1 angegebenen Maßnahmen. Dabei wird im Bereich der beim Ansteuern der Kondensatorelektrode im Halbleiter auftretenden Verarmungszone ein entgegengesetzt zum Halbleiterkörper dotiertes Diffusionsgebiet, das mit dem Eingang der Steuerinrichtung verbunden ist, elektrisch frei schwebend gehalten. Beim Ansteuern der Kondensator-elektrode (Anliegen einer Spannung) verteilt sich die in die Verarmungszone einfließende Ladung teilweise auch auf das Diffusionsgebiet und verändert das Oberflächenpotential dieses Diffusionsgebietes.

Dieses Potential wird von der Spannung der angesteuerten Elektrode erzeugt und ist im wesentlichen gleich dem Potential an der Halbleiteroberfläche unter der angesteuerten Elektrode. Durch die einfließende Ladung ist dieses Potential gegenüber dem Oberflächenpotential im angesteuerte, ungeladenen Zustand des Kondensators verändert. Durch entsprechendes Ansteuern einer Nachbarelektrode wird ein Potentialgefälle zu dem Nachbarkondensator erzeugt und die Ladung fließt dorthin ab. Das Diffusionsgebiet nimmt ohne Verwendung einer eigenen Rücksetzspannung ein entsprechendes Potential an. Die Differenz zwischen dem Oberflächenpotential des Diffusionsgebietes im angesteuerten, entsprechend der eingeflossenen Ladung geladenen Zustand des Kondensators und dem Oberflächenpotential des Diffusionsgebietes im ungeladenen Zustand des Kondensators entspricht der Größe der Signalladung und wird als Auslesesignal auf die spannungsgesteuerte Steuereinrichtung gegeben.

Bevorzugt wird die Elektrode (Lese-Elektrode) nicht im Takt des CCD-Registers angesteuert, sondern auf einer konstanten Spannung zwischen der Ruhespannung und der Taktspannung der Nachbarelektroden gehalten Beim Rücksetzen der im CCD-Register vorangehenden Elektrode von Taktspannung auf Ruhespannung entsteht dann ein Potentialgefälle im Halbleiter und die Signalladung kann unter die Lese-Elektrode fließen. Entsprechend entsteht beim Ansteuern der nachfolgenden Elektrode ein Potentialgefälle zum nachfolgenden Kondensator, die Ladung fließt vollständig ab und das Diffusionsgebiet nimmt ein Ruhepotential an, das allein von der Gleichspannung der Leseelektrode bestimmt wird (ohne Ansteuerung durch eine Rücksetzleitung). Vorteilhaft wird die Fläche der Leseelektrode gegenüber den anderen CCD-Elektroden vergrößert, damit der Lesekondensator die maximale Signalladung ganz aufnehmen kann.

Vorteilhaft wird als Steuereinrichtung ein auf dem Halbleiterkörper integrierter MIS—Transistor verwendet, dessen Steuerelektrode auf das vom Diffusionsgebiet abgetastete Oberflächenpotential gelegt wird.

Das Wesen der Erfindung wird anhand von vier Figuren und einem Ausführungsbeispiel noch näher erläutert.

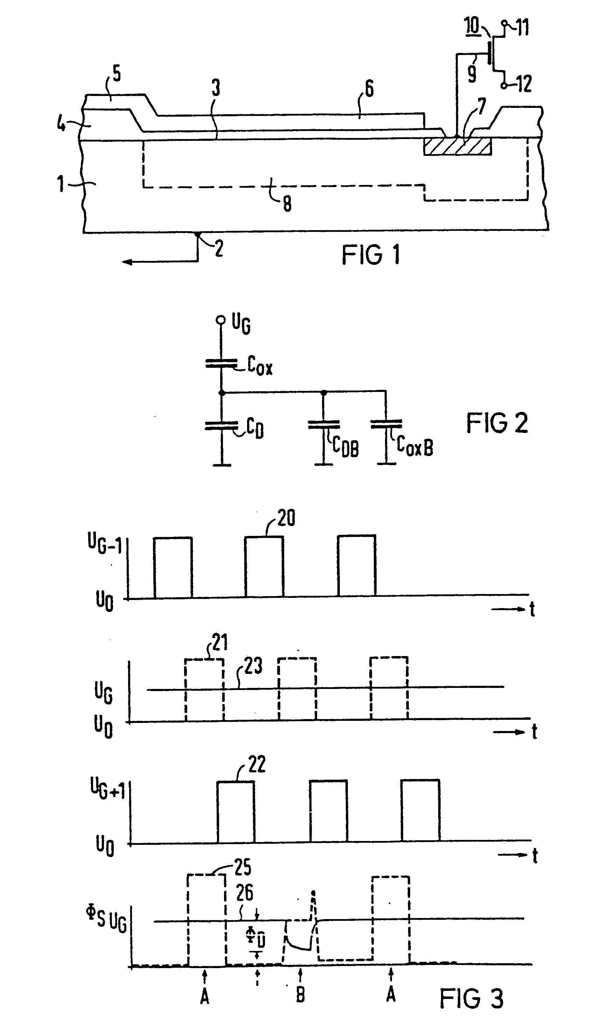

In Fig. 1 sit mit 1 schematisch ein dotierter Halbleiterkörper, vorzugsweise ein Halbleiterkörper aus Silizium mit einer p-Dotierung von $10^{14}$ bis $10^{15}$ cm$^{-3}$, bezeichnet und dessen Substratanschluß 2 angedeutet. Die Oberfläche des Halbleiterkörpers 1 ist mit einer vorzugsweise oxidischen Isolatorschicht 4 (z.B. $SiO_2$) bedeckt, die in den für die Kondensatoren des CCD-Registers vorgesehenen bereichen eine verhältnismäßig geringe Dicke (Gateorid, 60 nm), dazwischen eine größere Dicke (Feldoxid, z.B. 600 nm) aufweist. Über der Isolatorschicht ist eine Elektrodenschicht 5, z.B. ein hochdotierter Polysilizium-Streifen, aufgebracht, deren über dem Gateoxid 3 liegender Teil die Elektrode eines MIS—Kondensators des Schieberegisters bildet. Neben einer dieser Kondensator-Elektroden 6 ist ein entgegengesetzt dotiertes Gebiet, z.B. mit einer n$^+$-Dotierung von $10^{18}$ bis $10^{20}$ cm$^{-3}$ derart in der Halbleiteroberfläche angeordnet, daß bei einer positiven Vorspannung der Elektrode 6 gegenüber dem p-dotierten Substrat unter der Elektrode ein Verarmungsgebiet 8 entsteht, das das Diffusionsgebiet 7 einschließt. Dieses Verarmungsgebiet 7 ist mit dem Gate 9 eines MIS-Transistors 10 kontaktiert, dessen Drain und Source mit 11 und 12 bezeichnet sind. Vorteilhaft ist dieser Transistor, der als Steuereinrichtung dient, ebenfalls auf dem Halbleiterkörper integriert. Seine Herstellung kann gleichzeitig mit der Herstellung des Schieberegisters erfolgen.

In Fig. 2 ist ein Ersatzschaltbild gezeigt, aus dem die dabei auftretenden Kapazitäten entnommen werden können. Mit $C_D$ ist die Kapazität zwischen der durch die Signalladung aufgeladenen Halbleiteroberfläche des Kondensators und dem Substrat, mit $C_{ox}$ die Kapazität zwischen der Halbleiteroberfläche und der auf Gate-Spannung $U_G$ liegenden Elektrode 6 bezeichnet. Zu diesen auch bei anderen Kondensatoren des Schieberegisters auftretenden Kapazitäten treten die mit $C_{DB}$ bezeichnete Kapazität zwischen dem Diffusionsgebiet 7 und dem Substrat und die mit $C_{OXB}$ bezeichnete Kapazität des Transistors hinzu.

Die Elektroden liegen auf einem gegenüber dem Substratanschluß positiven Ruhepotential $U_o$ und werden kurzfristig auf ein höheres Potential $U'_G$ gelegt. In Fig. 3 ist mit den Kurven 20 und 22 die mit $U_{G-1}$ bzw. $U_{G+1}$ bezeichnete Spannung an der im CCD—Register zur Leseelectrode vorangehenden bzw. nachfolgenden Elektrode beim Takten gezeigt. Die Kurven 21 und 23 zeigen die an die Leseelektrode angelegte Spannung $U_G$ für den Fall, daß die Leseelectrode im CCD—Takt getaktet bzw. ungetaktet auf einer mittleren Gleichspannung gehalten wird. Die einzelnen Spannungsimpulse überlappen sich dabei geringfügig, damit die unter einer Elektrode während eines Spannungsimpulses gehaltene Ladung sich während der Überlappung auf beide Elektroden verteilen und nach dem Rücksetzen des Potentials der

3

ersten Elektrode unter die nächste Elektrode fließen kann.

Mit den Kurven 25 und 26 ist das Oberflächenpotential unter der Lese-Elektrode jeweils für die getaktete und ungetaktete Leseelectrode 6 gezeigt. Der Fall A liegt vor, wenn während des entsprechenden Impulses an der Elektrode 6 in dem Kondensator keine Signalladung enthalten ist, und der Fall B, wenn Signalladung durch den Kondensator geschoben wird. Im Fall A folgt das Oberflächen-potential $\emptyset_s$ im wesentlichen der der Elektrodenspannung $U_G$. Dieses Potential wird von dem Diffusions-gebiet abgetastet und auf das Gate des Transistors 10 übertragen. Im Fall B, in dem Signalladung unter die Elektrode 6 einfließt, wird ein Teil der Spannungsdifferenz zwischen der Elektrode 6 und dem Substratanschluß bereits durch die an der Oberfläche angesammelte Ladung abgebaut, das Oberflächenpotential nimmt daher geringere Werte an als im Fall A. Die Differenz $\emptyset_D$ des Oberflächen-potentials in den Fällen A und B entspricht der Menge der auszulesenden Ladung. Während der Überlappung mit dem Takt der nachfolgenden Elektrode fließt die Ladung in den nachfolgenden Kondensator ab und das Oberflächenpotential wird rückgesetzt. Dabei kann der Fall eintreten, daß bei Ansteuerung der Leseelektrode im CCD—Takt die Ladung nicht vollständig abfließt und ein Ladungsrest zurückbleibt, so daß das Oberflächenpotential unter der Leseelektrode (und damit im Diffusionsgebiet) nicht vollständig auf den durch $U_G$ vorgegebenen Wert zurückgeht. Bei Ansteuerung der Leseelektrode mit einer ungetakteten mittleren Gleichspannung tritt dies nicht auf.

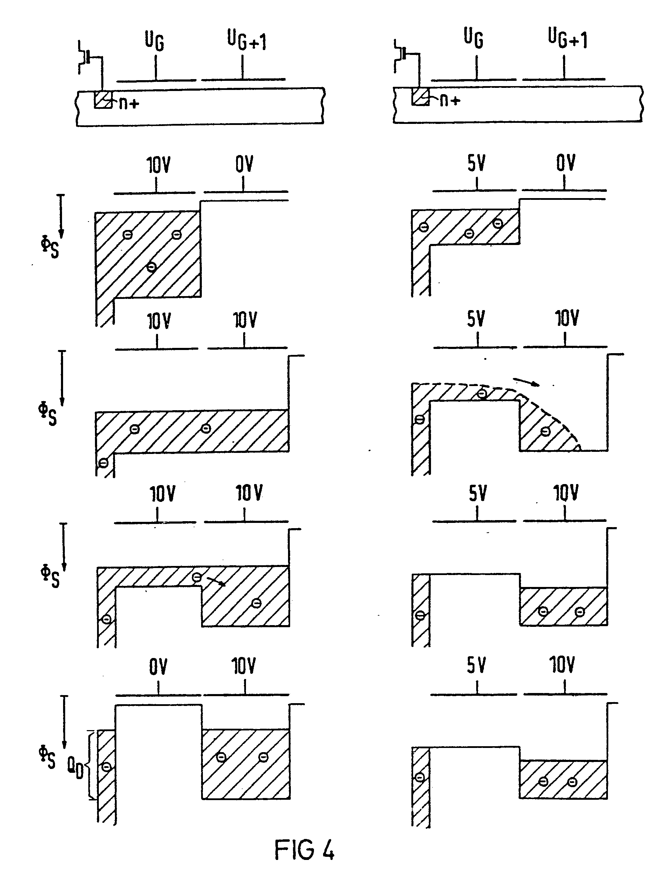

Fig. 4 zeigt diese Verhältnisse beim Abfließen der Signalladung, wobei die linke Seite den Potentialverlauf und die Ladung unter der getakteten Leseelektrode darstellt, insbesondere den verbleibenden Ladungsrest $Q_D$ und die Abweichung des Potentials nach dem Rücksetzen. Die rechte Seite verdeutlicht, daß bei ungetakteter Leseelektrode stets eine konstante Restladung verbleibt, die weder das Potential nach den Rücksetzen noch die Signalladung beeinflußt.

Des Diffusionsgebiet tastet das Oberflächenpotential unter der Elektrode 6 ab und gibt es an das Gate des Transistors 10 weiter. Die Signalladung selbst bleibt dabei erhalten. Am Transistorgate liegt dann also eine Steuerspannung an, die im Falle A einen hohen Signalhub bewirkt, der der Signalladung $O_s$ entspricht. Im Fall B ist der Signalhub entsprechend kleiner. Wird der Transistor z.B. zum Steuern eines Stromes verwendet, so entspricht der während des hohen Signalhubes fließende Strom dem Zustand fehlender Signalladung und die Differenz der Ströme zum Fall des verringerten Spannungshubes entspricht der Größe der fließenden Signalladung.

Die Kapazitäten $C_{DE}$ und $C_{OXB}$ stellen dabei eine Belastung der Kapazität des Kondensators dar. Ein Teil $Q_B$ der Signalladung fließt in diese Kapasitäten. Dadurch wird der Spannungshub etwas verkleinert gegenüber dem Hub des Oberflächenpotentials unter einer Elektrode, in deren Nähe kein Diffusions-gebiet ist. Für $Q_B$ gilt verinfacht $Q_B = C_{DB} + C_{OXB} \cdot O_s$, wobei allerdings $C_B$ von $\emptyset_s$ abhängt. Die Belastung des Kondensators mit den Kapazitäten $C_{DB}$ und $C_{OXB}$ bewirkt daher, daß die Differenz der Spannungshübe zwischen dem leeren Zustand und dem Zustand mit Signalladung nicht mehr linear mit der Signalladung wächst. Jedoch zeigt es sich, daß diese Nichtlinearität geringgehalten werden kann, z.B. indem das Diffusionsgebiet auf eine kleine Fläche beschränkt wird.

Diese Art der Auskopplung und des Auslesenserscheint vor allem sinnvoll bei großfächigen CCD—-Elektroden.

Das Diffusionsgebiet kann dabei seitlich an der Elektrode 6 angeordnet sein, die Elektrode kann aber auch eine Aussparung aufweisen, unter der das Diffusionsgebiet angeordnet ist.

**Patentansprüche**

1. Verfahren zum zerstörungsfreien Auslesen eines einer in einem Schieberegsiter zu verschiebenden Ladung entsprechenden Signals aus dem Schieberegister, das aus auf einem dotierten Halbleiterkörper (1) angeordneten ladungsgekoppelten MIS—Kondensatoren besteht, wobei das Potential an der Halbleiteroberfläche unter wenigstens einer der Kondensatorelektroden (6) abgetastet und als Steuerspannung auf eine spannungsgesteuerte Steuereinrichtung (10) gegeben wird, dadurch gekennzeichnet, daß im Bereich (8) der beim Ansteuern der Kondensatorelektrode (6) im Halbleiterkörper (1) auftretenden Verarmungszone ein mit dem Eingang (9) der Steuereinrichtung (10) verbundenes, entgegengesetzt zum Halbleiterkörper dotiertes Diffusionsgebiet (7) derart elektrisch frei schwebend gehalten wird, daß bei Anliegen einer Spannung an der Kondensatorelektrode (6) eine in die Verarmungszone und teilweise auch in das Diffusionsgebiet einfließende Ladung im Diffusions-gebiet (7) ein Potential $\emptyset_s$ erzeugt, das dem von der Kondensatorelektrode (6) im geladen Zustand (B) des Kondensators in der darunterliegenden Halbleiteroberflächer erzeugten Oberflächenpotential entspricht, gegenüber dem Oberflächenpotential im ungeladenen Zustand (A) des Kondensators verändert ist und nach Abfließen der Ladung das Diffusionsgebiet ohne Verwendung einer eigenen Rücksetzspannung für das Diffusionsgebiet ein en dem ungeladenen Zustand des Kondensators entsprechenden Wer annimmt, und daß die Differenz $\emptyset_D$ zwischen dem Oberflächenpotential des Diffusionsgebietes im angesteuerten, geladenen Zustand (B) des Kondensators und dem Oberflächenpotential des Diffusionsgebietes, das dem angesteuerten, ungeladenen Zustand (A) des Kondensators entspricht, als Auslesesignal auf die spannungsgesteuerte Steuereinrichtung (10) gegeben wird.

2. Verfahren nach Anspruch 1, dadurch gekennzeichnet, daß das Oberflächenpotential auf die Steuerelektrode (9) eines als Steuereinrichtung dienenden, auf dem Halbleiterkörper integrierten MIS—Transistors gegeben wird.

3. Verfahren nach Anspruch 1 oder 2, dadurch gekennzeichnet, daß die mit dem Diffusionsgebiet (7) Zusammenwirkende Kondensatorelektrode (6) auf einer Gleichspannung (23) zwischen der Ruhespannung ($U_o$) und der Taktspannung (20, 22) der anderen Elektroden des Schieberegisters gehalten wird.

4. Vorrichtung zur Durchführung des Verfahrens nach einem der Ansprüche 1 bis 3, dadurch gekennzeichnet, daß auf einem dotierten Halbleiterkörper ein Schieberegister aus ladungsgekoppelten MIS—Kondensatoren angeordnet ist, daß die Halbleiteroberfläche ein unmittelbar neben einer Kondensatorelektrode (6) angeordnetes, entgegengesetzt zum Halbleiterkörper dotiertes Diffusionsgebiet (7) enthält und daß das Diffusionsgebiet mit der Steuerleitung einer Steuereinrichtung kontaktiert und elektrisch frei schwebend gehalten ist.

5. Vorrichtung nach Anspruch 4, dadurch gekennzeichnet, daß das Diffusionsgebiet (7) neben der Kondensatorelektrode angeordnet ist.

6. Vorrichtung nach Anspruch 4, dadurch gekennzeichnet, daß die Kondensatorelektrode (6) eine Aussparung aufweist und das Diffusionsgebiet unterhalb der Aussparung angeordnet ist.

7. Vorrichtung nach Anspruch 5 oder 6, dadurch gekennzeichnet, daß die Steuereinrichtung ein auf dem Halbleiterkörper integrierter MIS—Transistor (10) ist.

8. Vorrichtung nach Anspruch 7, dadurch gekennzeichnet, daß die Kapazitäten des MIS—Transistors (10) und des Diffusionsgebietes (7) klein sind gegenüber der Kapazität des MIS—Kondensators (6).

9. Vorrichtung nach Anspruch 8, dadurch gekennzeichnet, daß die Fläche des Diffusionsgebietes (7) klein ist gegenüber der Fläche der Kondensatorelektrode (6).

10. Vorrichtung nach einem der Ansprüche 4 bis 9, dadurch gekennzeichnet, daß die Kondensatorelektrode mit einer Gleichspannungsquelle verbunden ist.

11. Vorrichtung nach Anspruch 10, dadurch gekennzeichnet, daß die die mit dem Diffusionsgebiet zusammen wirkende Kondensatorelektrode (6) und die Elektrode des im Schieberegisters nachfolgenden Kondensators eine größere Fläche besitzen als die Elektroden der anderen Registerkondensatoren.

**Revendications**

1. Procédé pour la lecture sans effacement dans un registre à décalage d'un signal correspondant à une charge à décaler dans un registre à décalage qui est constitué par un condensateur MIS à couplage de charge disposé sur un corps semiconducteur dopé (1), le potentiel au niveau du semiconducteur étant détecté au moins sous une des électrodes (6) du condensateur et étant appliqué sous la forme d'une tension de commande à un dispositif de commande (10) contrôle par la tension, caractérisé par le fait que dans la partie (8) de la zone d'appauvrissement qui apparaît dans le corps semiconducteur (1) lors de la commande de l'électrode (6) du condensateur, une plage de diffusion (7) dopée en sens opposé par rapport au corps semiconducteur et reliée à l'entrée (9) du dispositif de commande (10) est maintenue de telle manière à l'état électriquement flottant que lors de l'application d'une tension à l'électrode (6) du condensateur, une charge qui pénètre dans la zone d'appauvrissement et en partie également dans la plage de diffusion (7) produit dans cette dernière un potentiel ($\emptyset_s$) qui correspond au potentiel de surface produit par l'électrode (6) du condensateur à l'état chargé (B) de ce dernier, dans la surface semiconductrice sous-jacente, qui est modifié par rapport au potentiel superficiel à l'état déchargé (A) du condensateur alors qu'après écoulement de la charge la plage de diffusion assume, sans mise en oeuvre d'une tension de remise à l'état initial qui lui soit propre, une valeur qui correspond à l'état non chargé du condensateur, et que la différence ($\emptyset_D$) entre la tension superficielle de la plage de diffusion à l'état attaqué et chargé (B) du condensateur et le potentiel superficiel de la plage de diffusion qui correspond à l'état attaqué et non chargé (A) du condensateur, est appliquée en tant que signal de lecture au dispositif de commande (10) contrôlé par la tension.

2. Procédé selon la revendication 1, caractérisé par le fait que le potentiel superficiel est appliqué à l'électrode de commande (9) d'un transistor MIS intégré sur le corps semiconducteur et servant de dispositif de commande.

3. Procédé selon la revendication 1 ou 2, caractérisé par le fait que l'électrode (6) du condensateur et qui coagit avec la plage de diffusion (7) est maintenue à une tension continue (23), entre la tension de repos ($U_o$) et la tension de cadence (20, 22) de l'autre électrode du registre à décalage.

4. Dispositif pour la mise en oeuvre du procédé selon l'une des revendication 1 à 3, caractérisé par le fait que sur un corps semiconducteur dopé est prévu un registre à décalage constitué par des condensateurs MIS à couplage de charges, que la surface semiconductrice comporte une plage de diffusion (7) dopée en sens inverse du corps semiconducteur et disposée dans le voisinage immédiat d'une électrode du condensateur, et que la plage de diffusion est contactée avec le conducteur de commande d'un dispositif de commande et est maintenue à l'état électriquement flottant.

5. Dispositif selon la revendication 4, caractérisé par le fait que la plage de diffusion (7) est disposée près de l'électrode du condensateur.

6. Dispositif selon la revendication 4, caractérisé par le fait que l'électrode (6) du condensateur comporte un évidement et que la plage de diffusion est disposée sous ce dernier.

7. Dispositif selon la revendication 5 ou 6, caractérisé par le fait que le dispositif de commande est constitué par un transistor MIS (10) intégré sur le corps semiconducteur.

8. Dispositif selon la revendication 7, caractérisé par le fait que les capacités des transistors MIS (10) et de la plage de diffusion (7) sont faibles par rapport à la capacité du condensateur MIS (6).

9. Dispositif selon la revendication 8, caractérisé par le fait que la surface de la plage de diffusion (7) est petite par rapport à la surface de l'électrode (6) du condensateur.

10. Dispositif selon l'une des revendications 4 à 9, caractérisé par le fait que l'électrode du condensateur est reliée à une source de tension continue.

11. Dispositif selon la revendication 10, caractérisé par le fait que l'électrode (6) du condensateur qui coagit avec la plage de diffusion, et l'électrode du condensateur suivant du registre à décalage possèdent une surface surface supérieure aux électrodes des autres condensateurs du registre.

## Claims

1. A process for the non-destructive read-out from a shift register of a signal, which corresponds to the charge to be shifted in the shift register, which consists of charge-coupled MIS-capacitors arranged on a doped semiconductor body (1), wherein the potential on the semiconductor surface below at least one of the capacitor electrodes (6) is sampled and transferred as a control voltage to a voltage-controlled control device (10), characterised in that in the region (8) of the depletion zone which is formed in the semi-conductor body (1) on operating the capacitor electrode (6), a diffusion zone (7) which is connected to the input (9) of the control device (10) and is oppositely doped to the semiconductor body, is kept electrically floating in such manner that, on application of a voltage to the capacitor electrode (6), a charge which flows into the depletion zone and partially into the diffusion zone, produces a potential $\emptyset_s$ in the diffusion zone (7) which corresponds to the surface potential produced by the capacitor electrode (6) in the charged state (B) of the capacitor in the underlying semiconductor surface and which is different in the uncharged state (A) of the capacitor in relation to the surface potential; that, after leakage of the charge, the diffusion zone without the use of a separate feed-back voltage for the diffusion zone, assumes a value, which corresponds to the uncharged state of the capacitor, and that the difference $\emptyset_D$ between the surface potential of the diffusion zone in the operated, charged state (B) of the capacitor, and the surface potential of the diffusion zone which corresponds to the operated, uncharged state (A) of the capacitor, is transferred to the voltage-controlled control device (10) as a read-out signal.

2. A process as claimed in Claim 1, characterised in that the surface potential is transferred to the control electrode (9) of a MIS-transistor which is integrated in the semiconductor body and serves as the control device.

3. A process as claimed in Claim 1 or Claim 2, characterised in that the capacitor electrode (6) which interacts with the diffusion zone (7) is kept at a direct voltage (23) lying between the equilibrium potential ($U_o$) and the pulse potential (20, 22) of the other electrodes of the shift register.

4. Apparatus for carrying out the process as claimed in one of Claims 1 to 3, characterised in that on a doped semiconductor body there is arranged a shift register which consists of charge-coupled MIS-capacitors; that the semiconductor surface contains a diffusion zone (7) which is doped oppositely to the semiconductor body and is arranged directly adjacent to a capacitor electrode (6); and that the diffusion zone is contacted by a control line of a control device and is kept electrically floating.

5. Apparatus as claimed in Claim 4, characterised in that the diffusion zone (7) is arranged alongside the capacitor electrode.

6. Apparatus as claimed in Claim 4, characterised in that the capacitor electrode (6) is provided with an opening and the diffusion zone is arranged below the opening.

7. Apparatus as claimed in Claim 5 or Claim 6, characterised in that the control device is an MIS-transistor (10) which is integrated in the semi-conductor body.

8. Apparatus as claimed in Claim 7, characterised in that the capacitances of the MIS-transistor (10) and of the diffusion zone (7) are small as compared with the capacitance of the MIS-capacitor (6).

9. Apparatus as claimed in Claim 8, characterised in that the surface of the diffusion zone (7) is small in comparison with the surface of the capacitor electrode (6).

10. Apparatus as claimed in any one of Claims 4 to 9, characterised in that the capacitor electrode is connected to a direct voltage source.

11. Apparatus as claimed in Claim 10. characterised in that the capacitor electrode (6) which interacts with the diffusion electrode, and the electrode of the following capacitor in the shift register, possess a larger surface than the electrodes of the other capacitors of the register.

0 006 975

FIG 1

FIG 2

FIG 3

FIG 4